# EUROPEAN PATENT APPLICATION

(11) **EP 1 626 502 A1**
(43) Date of publication of application: **15.02.2006**
(21) Application number: 04029178.3
(22) Date of filing: 09.12.2004
(51) Int. Cl.: H03L 7/197

(54) **Phase locked loop for controlling recordable optical disc drive and method thereof**

(30) Priority: 13.08.2004 US 710934
(71) Applicant: Mediatek Incorporation, Hsin-Chu Hsien (TW)
(72) Inventor: Chen, Hong-Ching, Feng-Shan City Kao-Hsiung Hsien (TW); Chang, Chi-Ming, Chung-Li City Tao-Yuan Hsien (TW)
(74) Representative: Schaeberle, Steffen

(57) **Abstract**

A PLL system (110, 210, 310, 410, 510, 610, 710, 810, 910) for generating an output signal according to a first reference signal is disclosed. The output signal is used as a reference clock to write recording data on an optical medium. The PLL system (110, 210, 310, 410, 510, 610, 710, 810, 910) includes a clock generator for receiving the first reference signal and a first frequency-divided signal to generate the output signal according to a phase difference between the first reference signal and the first frequency-divided signal; a phase-shift detector (170, 270, 370, 470, 570, 670, 770, 870, 970) for generating a phase adjusting signal; and a phase-controllable frequency divider (160, 260, 360, 460, 560, 660, 760, 860) electrically connected to the clock generator and the phase-shift detector (170, 270, 370, 470, 570, 670, 770, 870, 970) for dividing the output signal according to a frequency dividing ratio to generate the first frequency-divided signal and for receiving the phase adjusting signal to adjust the frequency dividing ratio.

## Description

The present invention relates to a phase locked loop which incorporates a phase shift detector and a phase controllable frequency divider, and a method for generating an output signal according to a first reference signal according to the pre-characterizing clauses of claims 1 and 25.

Generally speaking, a wobble signal is used as a reference to generate a write clock for recording data on an optical disc. Due to a phase shift phenomenon which occurs in the circuit, however, the system sometimes malfunctions, causing the recording quality to deteriorate. In addition, these phase shift phenomena accumulate resulting in serious recording deficiencies.

This in mind, the present invention aims at providing a phase locked loop incorporating a phase shift detector and a phase controllable frequency divider in order to generate a correct recording clock which will be free of the prior art phase shift phenomenon.

This is achieved by a phase locked loop which incorporates a phase shift detector and a phase controllable frequency divider, and a method for generating an output signal according to a first reference signal, according to claims 1 and 25 respectively. The dependent claims pertain to corresponding further developments and improvements.

As will be seen more clearly from the detailed description following below, the claimed phase locked loop includes a clock generator, a phase shift detector and a phase controllable frequency divider to eliminate the phase shift phenomena, no matter how big the aforementioned phase shift is.

In the following, the invention is further illustrated by way of example, taking reference to the following drawings. Thereof
Fig.1 is a diagram of a prior art PLL,
Fig.2 is a diagram illustrating the prior art phase shift phenomenon,
Fig.3 is a diagram illustrating the prior art recording offset,
Fig.4 is a block diagram of a phase locked loop (PLL) system according to the present invention,
Fig.5 is a flow chart illustrating the operation of tuning a count value utilized by a phase-controllable frequency divider shown in Fig.4,
Fig. 6 is a timing diagram illustrating the operations of a phase-shift detector and the phase-controllable frequency divider shown in Fig.4,
Fig.7 is a diagram illustrating the operation of adjusting the phase of an output clock locked in a wrong point to reach a correct point according to the present invention,
Fig.8 is a block diagram of a PLL system according to a first detailed embodiment of the present invention,
Fig.9 is a block diagram of a PLL system according to a second detailed embodiment of the present invention,
Fig.10 is a block diagram of a PLL system according to a third detailed embodiment of the present invention,
Fig.11 is a block diagram of a PLL system according to a fourth detailed embodiment of the present invention,
Fig.12 is a block diagram of a PLL system according to a fifth detailed embodiment of the present invention,
Fig.13 is a block diagram of a PLL system according to a sixth detailed embodiment of the present invention,
Fig.14 is a diagram illustrates the operation of the PLL system shown in Fig.13.
Fig.15 is a block diagram of a PLL system according to a seventh detailed embodiment of the present invention,
Fig.16 is a diagram illustrating the operation of the PLL system shown in Fig.15,
Fig.17 is a block diagram of another system according to the present invention, and
Fig.18 is a diagram illustrating the operation of the system shown in Fig. 17.

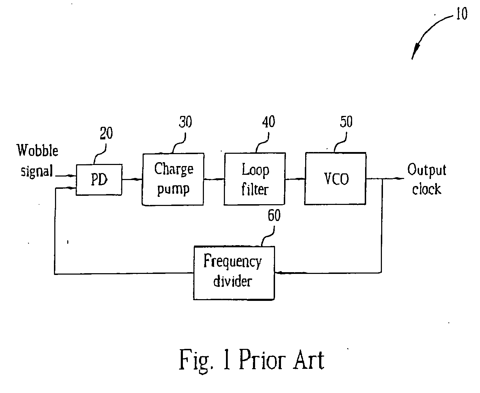

Please refer to Fig.1, which is a diagram of a prior art PLL 10. As shown in Fig.1, the prior art PLL 10 generates an output clock in response to a wobble signal extracted from the wobble tracks on a recordable optical disc. The output clock is used to control the writing path of a recordable optical disk drive (e.g. a DVD-R/RW drive or a DVD+R/RW drive) and is the reference for the recording bit clock. The PLL 10 includes a phase detector (PD) 20, a charge pump 30, a loop filter 40, a voltage-controlled oscillator (VCO) 50, and a frequency divider 60. The PD 20 is used for detecting the phase difference between the wobble signal and a divided signal generated from the frequency divider 60 to output a phase error to the charge pump 30. The charge pump 30 is used for generating a current based on the phase error generated by the PD 20. After the loop filter 40 receives the current outputted from the charge pump 30, the loop filter 40 is capable of generating a loop filter voltage to drive the following VCO 50. It is well known that the VCO 50 alters the frequency of its outputted clock according to the inputted voltage. In other words, the VCO 50 receives the voltage outputted from the loop filter 40, and generates the output clock with a specific frequency according to the received voltage. Generally, the clock signal utilized by the recordable optical disk drive has the frequency higher than that of the wobble signal. Thus the VCO 50 is designed to output a high-frequency clock. It is obvious that the frequency divider 60 is needed for dividing the frequency of the output clock outputted from the VCO 50 to generate the frequency-divided signal delivered to the PD 20.

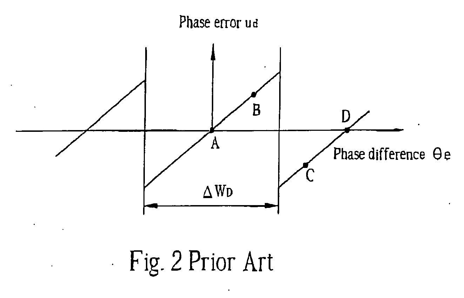

But, in fact, the prior art PLL 10 sometimes cannot make the phase of the output clock in synchronization with that of the wobble signal because of the phase shift phenomenon. The phase shift phenomenon is due to the circuit characteristic of the PD 20. Please refer to Fig.2, which is a diagram illustrating the prior art phase shift phenomenon. The horizontal axis represents the phase difference *θ* e between the wobble signal and the frequency-divided signal inputted into the PD 20, and the vertical axis stands for the phase error *µ*_{d} outputted from the PD 20. In addition, the symbol ΔW_{d} is the detection range of the PD 20. As shown in Fig.2, it can be easily seen that the phase difference *θ* e is not necessarily equal to zero if the phase error *µ*_{d} equals zero. If the phase difference *θ*e is within the detection range ΔW_{d} of PD 20 (the point B shown in Fig.2), the PLL 10 tracks and reduces the phase difference *θ*e to zero (the point A shown in Fig.2). But if the phase difference *θ*e is outside the detection range ΔW_{d} of the PD 20 (the point C shown in Fig.2), the outputted phase error *µ*_{d} makes the PLL 10 increase the current phase difference lock for locking the phase to another zero-crossing point (the point D shown in Fig.2) rather than the desired one (the point A shown in Fig.2). Therefore, the phase shift phenomenon occurs to make the PLL 10 malfunction.

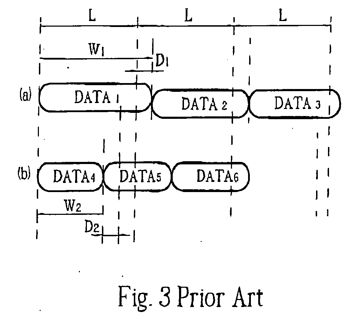

Concerning the recording operation, if the phase shift phenomenon occurs, the absolute length of recorded data, which is synchronous to the output clock of the PLL 10, is affected to be longer or shorter than a normal length. Consequentially, the recording quality is deteriorated. Please refer to Fig.3, which is a diagram illustrating the prior art recording offset. The top shows the case that the length of recorded data is longer than a normal length, and the bottom shows another case that the length of recorded data is shorter than the normal length. Suppose that the normal length of each data block DATA₁, DATA₁, DATA₁, DATA₁, DATA₁, DATA₆ is L. As shown in Fig.3, the length W₁ of the data block DATA₁ is longer than the normal length L. Therefore, a recording offset D₁ is introduced to the recording process, and affects the recording of the following data blocks DATA₂ and DATA₃. Similarly, as shown in Fig.3, the length W₂ of the data block DATA₄ is shorter than the normal length L, and a recording offset D₂ is generated. Therefore, the recording of the following data blocks DATA₅ and DATA₆ are affected accordingly. The length variation of recorded data causes the position of recorded data shifted from an ideal position specified by the recording specification. As mentioned above, each recording offset due to the phase shift phenomenon is accumulated so that a serious recording problem is sure to occur.

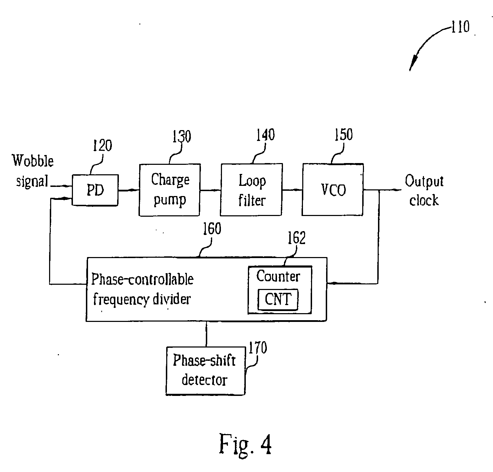

Please refer to Fig.4, which is a block diagram of a phase locked loop (PLL) system 110 according to the present invention. The PLL system 110 includes a phase-controllable frequency divider 160, a phase-shift detector 170, a phase detector (PD) 120, a charge pump 130, a loop filter 140, and a voltage-controlled oscillator (VCO) 150. Functionality of the PD 120, the charge pump 130, the loop filter 140, and the VCO 150 is the same as that of the those components of the same name in the prior art PLL 10, and thus the lengthy description is omitted here for simplicity. In other words, the PD 120, the charge pump 130, the loop filter 140, and the VCO 150 function as a clock generator for generating a wanted output clock. The phase-controllable frequency divider 160 acts as a feedback device for tuning the clock generator. The phase-shift detector 170 is used to detect the direction and the amount of the phase shift, and outputs a phase-adjusting signal to the phase-controllable frequency divider 160. The phase-controllable frequency divider 160 is capable of dividing the frequency of the output clock and adjusting the phase of the output clock according to the detection result outputted from the phase-shift detector 170. In this embodiment, the phase-controllable frequency divider 160 has a counter 162 for storing a count value CNT.

This count value CNT determines the frequency dividing ratio and the phase associated with the frequency-divided signal. The operations of the phase-shift detector 170 and the phase-controllable frequency divider 160 are further detailed as follows.

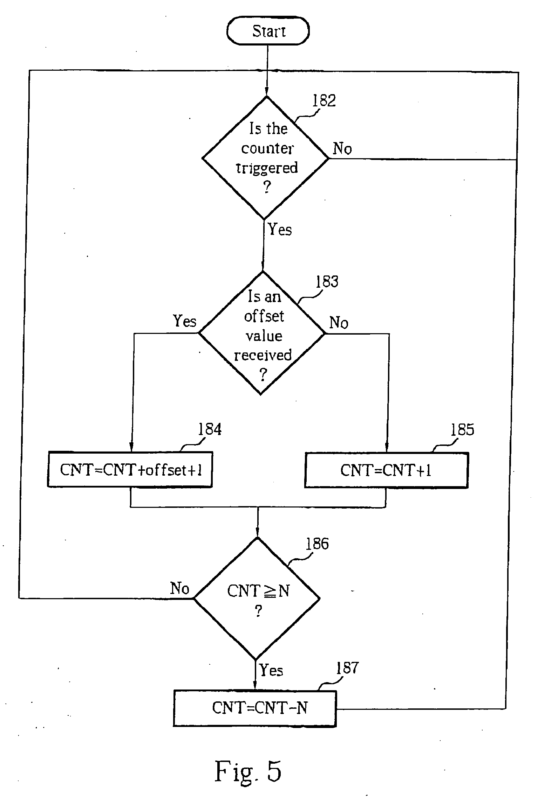

Please refer to Fig.5 in conjunction with Fig.4. Fig.5 is a flow chart illustrating the operation of tuning the count value CNT utilized by the phase-controllable frequency divider 160 shown in Fig.4. As mentioned above, the phase-controllable frequency divider 160 is connected to the VCO 150 for receiving the output clock. In this embodiment, the counter 162 within the phase-controllable frequency divider 160 is trigged by each cycle of the output clock, and then the phase-controllable frequency divider 160 controls the frequency-divided signal to toggle if the count value CNT counted by the counter 162 reaches a threshold value N. In other words, if the frequency of the output clock is equal to F, the frequency of the frequency-divided signal equals F/N. As described before, the prior art phase shift phenomenon affects the PLL system 110 to correctly lock to the desired phase for the output clock. Therefore, the phase-shift detector 170 is utilized to measure an actual phase shift deviated from the desired phase, and outputs the phase-adjusting signal to the phase-controllable frequency divider 160 according to the detected phase shift. An offset value is transmitted to the phase-controllable frequency divider 160 through the phase-adjusting signal. The operation of setting the count value CNT is detailed as follows. When the counter 162 within the phase-controllable frequency divider 160 is triggered by a rising edge or a falling edge of a cycle of the output clock, the count value CNT is required to be adjusted (step 182). Then, the existence of the offset value is checked (step 183). Therefore, if the phase-shift detector 170 detects a phase shift affecting the output clock, the offset value to delivered to the phase-controllable frequency divider 160. The count value CNT, in this embodiment, is updated by a new value equaling CNT+offset+1 (step 184). On the contrary, if the phase-shift detector 170 detects no phase shift affecting the output clock, no offset value is outputted to the phase-controllable frequency divider 160. The count value CNT, in this embodiment, is updated by a new value equaling CNT+1 (step 185). Then, if the newly updated count value CNT reaches the threshold value N, the phase-controllable frequency divider 160, as mentioned above, controls the frequency-divided signal to toggle. Therefore, the count value CNT is further updated by a new value equaling CNT-N (step 187). However, if the newly updated count value CNT is still less than the threshold value N, the count value CNT is unchanged.

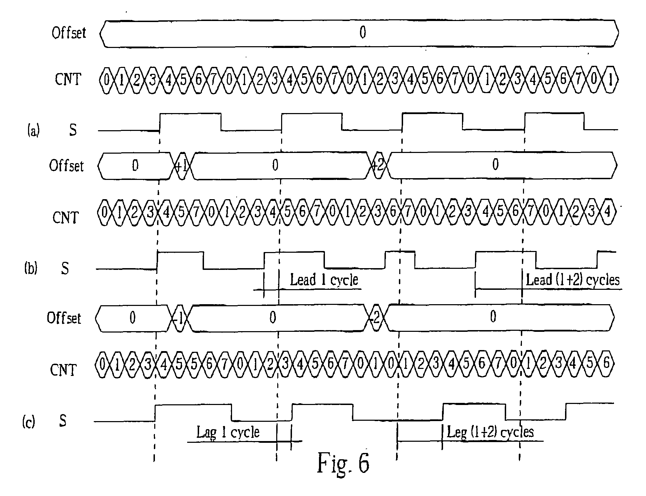

Please refer to Fig.6 in conjunction with Figs.4 and 5. Fig.6 is a timing diagram illustrating the operations of the phase-shift detector 170 and the phase-controllable frequency divider 160 shown in Fig.4. If the phase-shift detector 170 is disabled, the count value CNT' is counted normally, and the frequency-divided signal S' toggles when the count value CNT' is equal to 4. In addition, after the frequency-divided signal S' toggles, the count value CNT' is reset to hold its initial value 0. However, when the phase-shift detector 170 is activated to detect the phase shift for generating the offset value, the count value CNT is tuned to alter the phase of the frequency-divided signal S. It is easily seen that the phase of the frequency-divided signal S is controlled to lead the phase of the frequency-divided signal S' when the offset value is set to a positive value (e.g. +1 or +2), and the phase of the frequency-divided signal S is controlled to lag the phase of the frequency-divided signal S' when the offset value is set to a negative value (e.g. -1 or -2). As shown in Figs. 5 and 6, when the phase-shift detector 170 does not transfer any phase-shift signal to the phase-controllable frequency divider 160, the offset value is 0 and the counter 162 sequentially counts the cycles of the output clock for generating the frequency-divided signal. But if the phase-shift detector 170 transfers the phase-shift signal to the phase-controllable frequency divider 160, the offset value is +1, +2, -1, or -2, and the count value CNT' is changed because of the inputted offset value. This also means that the timing when the frequency-divided signal toggles is changed so that the frequency dividing ratio is adjusted accordingly. That is, the phase of the frequency-divided signal is therefore shifted according to the imposed phase shift detected by the phase-shift detector 170.

I t is clear that adjusting the count value CNT is equivalent to temporarily altering the frequency dividing ratio. The timing when the frequency-divided signal toggles is changed if the frequency dividing ratio varies. In other words, one period of the frequency-divided signal outputted from the phase-controllable frequency divider 160 is increased or decreased through the control of the offset value. As described above, the count value CNT adjusted by the offset value controls the timing when the frequency-divided signal toggles. However, other techniques can be adopted get the same result. For example, the count value CNT is incremented normally, and the threshold value N is adjusted by the offset value. The same objective of controlling the phase of the frequency-divided signal is fulfilled.

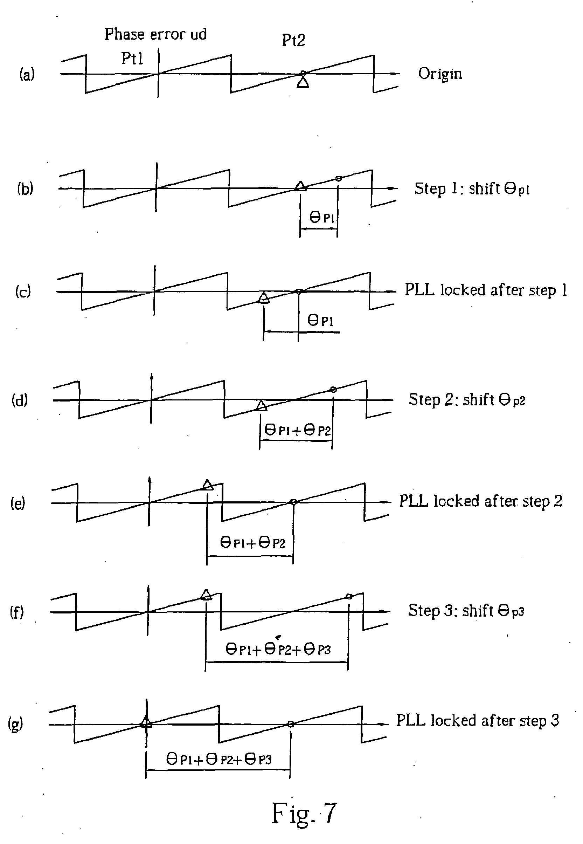

Because the phase of the frequency-divided signal is shifted before the frequency-divided signal is passed to the PD 120, the phase of the output clock locked by the PLL system 110 moves. In the end, the phase of the output clock is locked through the normal detection range of the PD 120. Please refer to Fig.7, which is a diagram illustrating the operation of adjusting the phase of the output clock locked in a wrong point to reach a correct point according to the present invention. The horizontal axis represents the phase difference between the wobble signal and the frequency-divided signal inputted into the PD 20, and the vertical axis stands for the phase error outputted from the PD 20. Suppose that the prior art phase shift phenomenon happens to the PLL system 110, and the phase of the frequency-divided signal leads that of the wobble signal. In other words, the output clock is locked to an erroneous phase, a phase difference between the wobble clock and the frequency-divided signal corresponding to the erroneously locked output clock is outside the detection range ΔW_{d} of the PD 120. As shown in Fig.7, the phase difference is equal to *θ*ₚ₁+*θ*ₚ₂+*θ*ₚ₃ instead of zero. In addition, the phase of the output clock leads the required phase by *θ*ₚ₁+*θ*ₚ₂+*θ*ₚ₃, and the output clock corresponds to the zero-crossing point Pₜ shown in Fig.6.

Firstly, the phase-controllable frequency divider 160 adjusts the phase of the frequency-divided signal by a phase increment *θ*ₚ₁ to increase the phase difference between the wobble signal and the frequency-divided signal according to the phase-adjusting signal outputted from the phase-shift detector 170. That is, the PD 120 corresponds to the point P₁ now. Please note that the phase of the output clock is not adjusted yet, and the phase difference between the wobble signal and the frequency-divided signal becomes 2* *θ*ₚ₁+*θ*ₚ₂+*θ*ₚ₃. Then, the PLL system 110 works to reduce the added phase increment *θ*ₚ₁. That is, the PLL system 110 lags the phase of the output clock by the phase increment *θ*ₚ₁, and the phase of the output clock leads the required phase by *θ*ₚ₂+*θ*ₚ₃ instead of *θ*ₚ₁+*θ*ₚ₂+*θ*ₚ₃. In addition, the output clock equivalently corresponds to the point P₁'. When the adjusted output clock is transmitted to the phase-controllable divider 160, the phase difference between the frequency-divided signal and the wobble signal becomes *θ*ₚ₁+*θ*ₚ₂+*θ*ₚ₃, and the PD 120 corresponds to the point Pₜ again.

Secondly, the phase-controllable frequency divider 160 further adjusts the phase of the frequency-divided signal by a phase increment *θ*ₚ₂ to increase the phase difference between the wobble signal and the frequency-divided signal according to the phase-adjusting signal outputted from the phase-shift detector 170. That is, the PD 120 corresponds to the point P₂ now. Please note that the phase of the output clock is not adjusted yet, and the phase difference between the wobble signal and the frequency-divided signal becomes *θ*ₚ₁+2* *θ*ₚ₂+*θ*ₚ₃. Then, the PLL system 110 works to reduce the added phase increment *θ*ₚ₂. That is, the PLL system 110 lags the phase of the output clock by the phase increment *θ*ₚ₂, and the phase of the output clock leads the required phase by *θ*ₚ₃ instead of *θ*ₚ₂+*θ*ₚ₃. In addition, the output clock equivalently corresponds to the point P₂'. When the adjusted output clock is transmitted to the phase-controllable divider 160, the phase difference between the frequency-divided signal and the wobble signal becomes *θ*ₚ₁+*θ*ₚ₂+*θ*ₚ₃, and the PD 120 corresponds to the point Pₜ again.

Finally, the phase-controllable frequency divider 160 further adjusts the phase of the frequency-divided signal by a phase increment *θ*ₚ₃ to increase the phase difference between the wobble signal and the frequency-divided signal according to the phase-adjusting signal outputted from the phase-shift detector 170. That is, the PD 120 corresponds to the point P₃ now. Please note that the phase of the output clock is not adjusted yet, and the phase difference between the wobble signal and the frequency-divided signal becomes *θ*ₚ₁+ *θ*ₚ₂+2* *θ*ₚ₃. Then, the PLL system 110 0 works to reduce the added phase increment *θ*ₚ₃. That is, the PLL system 110 lags the phase of the output clock by the phase increment *θ*ₚ₃, and then the phase of the output clock is identical to the required phase. In addition, the output clock equivalently corresponds to the point P₃'. When the adjusted output clock is transmitted to the phase-controllable divider 160, the phase difference between the frequency-divided signal and the wobble signal becomes *θ*ₚ₁+*θ*ₚ₂+*θ*ₚ₃, and the PD 120 corresponds to the point Pₜ again. As mentioned above, the offset values computed by the phase-shift detector 170 are capable of gradually tuning the phase of the output clock to eliminate the prior art phase shift phenomenon imposed upon the output clock.

When the phase adjusting operation responses to the output of VCO 150, the variation of output clock is very smooth due to the loop filter 140. Please note that the phase increments *θ*ₚ₁, *θ*ₚ₂, *θ*ₚ₃ caused by the offset values are not allowed to exceed half of the detection range ΔW_{d}. If one phase increment *θ*ₚ is greater than half of the detection range ΔW_{d}, the PLL system 110 makes the phase of the output clock locked to another phase further deviated from the required one. This is not what we like to see. Therefore, no matter how large the amount of unwanted phase shift is, the present invention is capable of adjusting the phase shift by a plurality of phase adjustments. As mentioned above, the phase *θ*ₚ is smaller than half of the detection range ΔW_{d}. For example, if the detection range ΔW_{d} is 8T, the selected phase increment *θ*ₚ is defined as 2T, and the initial amount of detected phase shift is 48T, it only needs 24 (48T/2T) times of phase adjustments to compensate the phase shift imposed upon the output clock.

Please note that the components of the same name among the PLL system 110 shown in Fig.4 and the following embodiments have the same functionality and operation. Therefore, the lengthy description for the identical component in each alternative embodiment disclosed later is not repeated for simplicity.

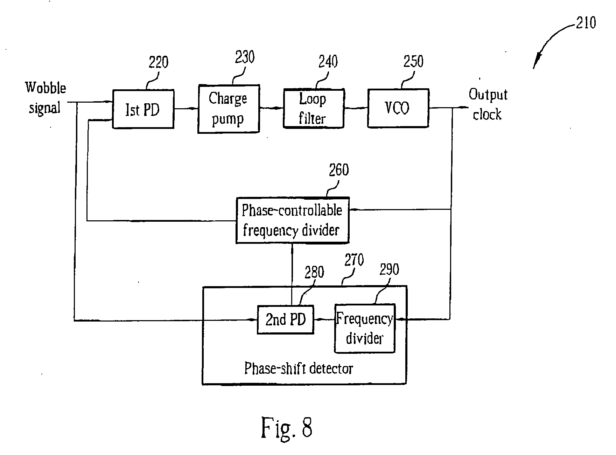

Please refer to Fig.8, which is a block diagram of a PLL system 210 according to a first detailed embodiment of the present invention. The PLL system 210 comprises a first PD 220, a charge pump 230, a loop filter 240, a VCO 250, a phase-controllable frequency divider 260, and a phase-shift detector 270. In this embodiment, the phase-shift detector comprises a second PD 280 and a frequency divider 290. The frequency divider 290 divides the frequency of the output clock, and sends the frequency-divided output clock into the PD 280. Therefore, as shown in Fig.8, the second PD 280 is capable of detecting the phase difference between the divided output clock and the wobble signal to estimate the phase shift imposed upon the output clock. Please note that the phase-controllable frequency divider 260 divides the frequency of an incoming signal by N, but the frequency divider 290 is user to divide the frequency of an incoming signal by K, where K>N. The reason why K is required to be greater than N is to enlarge the detection range. For example, assume that k is set to 32, and N is set to 8. Concerning the DVD+R/RW application, if the phase shift is larger than 4T but lower than 16T, the first PD 220 is unable to detect the phase shift, but the second PD 280 can detect this phase shift. Therefore, the phase shift detector 270 of this embodiment is capable of generating the phase-adjusting signals to the phase-controllable frequency divider 260 according to the detected phase shift.

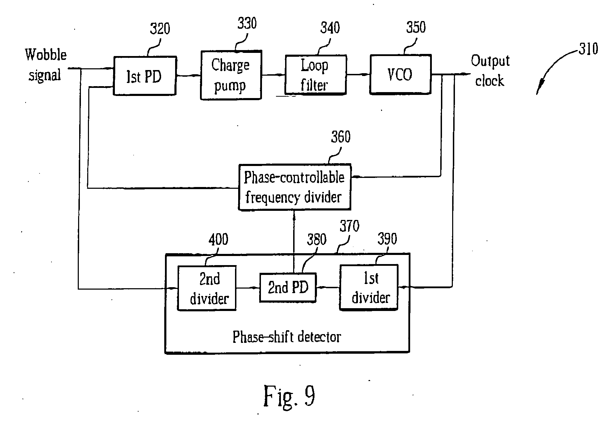

Similarly, please refer to Fig.9, which is a block diagram of a PLL system 310 according to a second detailed embodiment of the present invention. The PLL system 310 also comprises a first PD 320, a charge pump 330, a loop filter 340, a VCO 350, a phase-controllable frequency divider 360, and a phase-shift detector 370. However, the phase-shift detector 370 comprises a second PD 380, a first divider 390, and a second divider 400. The only difference between the first detailed embodiment and this second detailed embodiment is the second divider 400, which is utilized to divide the wobble signal so that the detection range is capable of being larger than that in the fust detailed embodiment.

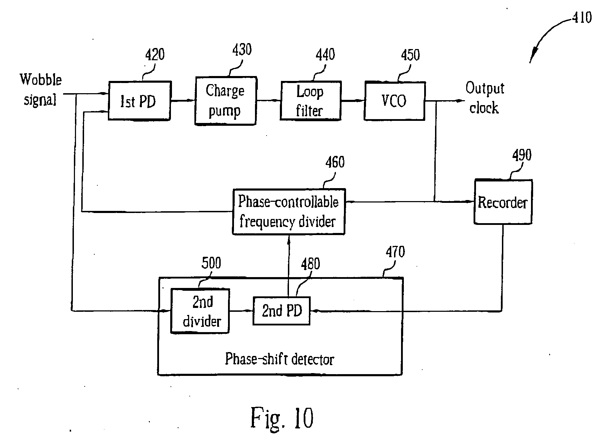

Please refer to Fig.10, which is a block diagram of a PLL system 410 according to a third detailed embodiment of the present invention. The PLL system 410 also comprises a first PD 420, a charge pump 430, a loop filter 440, a VCO 450, a phase-controllable frequency divider 460, and a phase-shift detector 470. The phase-shift detector 470 comprises a second PD 480. Here, the output clock is outputted into the recorder 490. For example, the recorder 490 can be a DVD+R/RW recording device or a DVD-R/RW recording device. Therefore, in this embodiment, a recording sync signal generated by the recorder 490 synchronous to the recording data is inputted into the second PD 480 to serve as a reference clock. As shown in Fig.10, the second PD 480 generates phase-adjusting signals according to the phase difference between the wobble signal and the inputted recording sync signal. In the case, the recording sync signal can be the even frame sync signal that indicating the even frame sync of the recording data. In addition, the phase-shift detector 470 can further comprise an optional frequency divider 500 shown in Fig. 10. This optional frequency divider 500 is used to divide the frequency of the wobble signal. Thus, the detection range is enlarged.

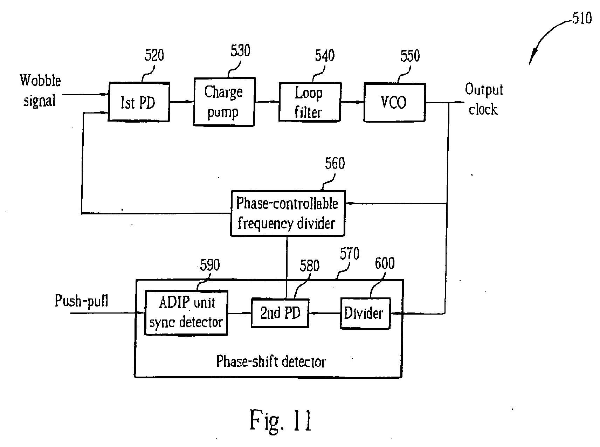

In addition to the wobble signal, information related to the physical address can also be used as the reference for the phase-shift detector. Please refer to Fig.11, which is a block diagram of a PLL system 510 according to a fourth detailed embodiment of the present invention. This embodiment is quite similar to the first embodiment shown in Fig.10. However, the phase-shift detector 570 comprises an ADIP frame sync detector 590. Apparently, this embodiment is applied to the DVD+R/RW recording device. The ADIP frame sync detector 590 can generate an ADIP frame sync signal used for indicating the phase change of the first wobble within an ADIP unit (8 wobbles). According to the DVD+R/RW specification, the period of one ADIP unit corresponds to 93 wobbles. As shown in Fig.11, the phase-shift detector 570 uses the ADIP frame sync signal and the divided output clock generated from the frequency divider 600 to generate the phase-adjusting signal.

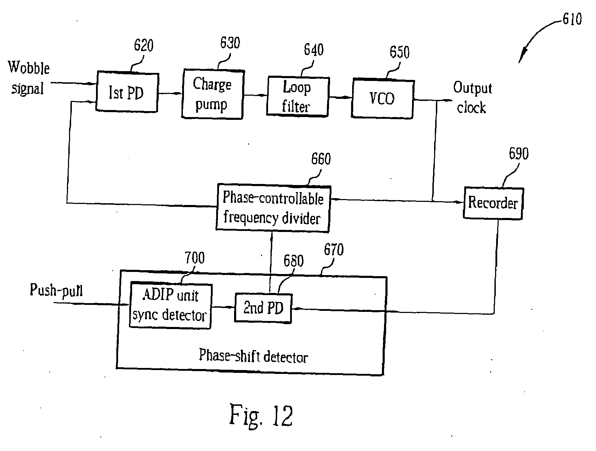

Please refer to Fig. 12, which is a block diagram of a PLL system 610 according to a fifth detailed embodiment of the present invention. This embodiment is similar to the third detailed embodiment shown in Fig.12. It is the same that the recording sync signal is utilized as a reference clock. The difference is to utilize the ADIP frame sync signal as another reference clock. Therefore, the phase-shift detector 670 generates the phase-adjusting signal according to the phase difference between the recording sync signal and the ADIP frame sync signal. According to the DVD+R/RW specification, an ideal phase difference between the recording sync signal and the ADIP frame sync signal is defined to be 16 wobbles. In other words, if the actual phase difference between the recording sync signal and the ADIP frame sync signal is different from the defined value, the phase shift imposed upon the output clock can be correctly estimated.

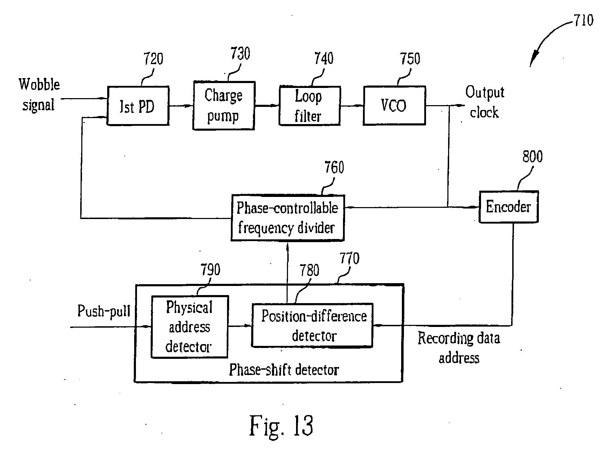

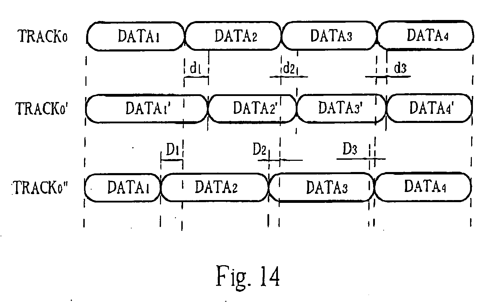

Additionally, in the fourth and fifth detailed embodiments shown in Figs.13 and 14, if a larger detection range is required, the ADIP sync signal can be replaced by an ADIP word sync signal, which is used to indicate the position of the ADIP word sync. Besides, as mentioned above, the fourth and fifth detailed embodiments are only utilized in DVD+R/RW recording applications because only DVD+R/RW disc has ADIP information thereon. Therefore, when the DVD-R/RW recording application is adopted, the land pre-pit (LPP) sync signal is utilized instead as a reference clock according to the DVD-R/RW specification.

As mentioned above, the phase-shift detector generates phase-adjusting signals according to the phase difference between two reference signals (for example, a wobble signal and an ADIP frame sync signal). But in fact, the phase-shift detector is capable of being utilized to generate phase-adjusting signals according to the position difference between the ideal position and the practical position of recording data addresses. As shown in Fig.3, the data length of the recorded data is too long or too short due to the prior art phase shift phenomenon. Therefore, the position deviation can be utilized to estimate the phase shift. Please refer to Fig. 13, which is a block diagram of a PLL system 710 according to a sixth detailed embodiment of the present invention. Please note that, in this embodiment, the phase-shift detector 770 comprises a position difference detector 780 instead of the phase detector utilized in above-mentioned embodiments. The output clock is inputted into the encoder 800 for driving the encoder 800 for producing the recording data and defining recording data addresses corresponding to the recording data. Please note that the recording data addresses correspond to actual physical addresses of the recording data stored on the recordable optical disk. Therefore, when the recording data are being recorded onto a recordable optical disk, the encoder 800 outputs corresponding recording data addresses to the position difference detector 780.

In this embodiment, the phase-shift detector 770 further comprises a physical address detector 790 for detecting ideal physical addresses corresponding to the recording data stored on the recordable optical disk (e.g. a DVD+R/RW disc or a DVD-R/RW disc) through a well-known push-pull signal read from the recordable optical disk. The phase-shift detector 770 generates the phase-adjusting signal according to the position difference between the recording data address and the ideal data address. Please note that, in this embodiment, the phase-shift detector 770 detects the position difference and generates the phase-adjusting signal when the recording data are being recorded on the recordable optical. In another words, every time when a new data block is recorded on the recordable optical disc, the phase-shift detector 770 detects the position difference and generates the phase-adjusting signal to the phase-controllable frequency divider 760 to compensate the output clock for the phase shift imposed thereon. Accordingly, the recording data address assigned to the next data block is tuned after the adjusted output clock is delivered to the encoder 800.

Please refer to Fig. 14, which is a diagram illustrates the operation of the PLL system 710 shown in Fig.13. The track TRACK₀ shows the ideal positions of a plurality of data blocks DATA₁, DATA₂, DATA₃, DATA₄. It is obvious that each of the data blocks DATA₁, DATA₂, DATA₃, DATA₄ has an identical data length. Concerning the track TRACK₀', it shows a data block DATA₁' affected by the prior art phase shift. Compared with the data block DATA₁, this data block DATA₁' has a longer data length. Therefore, the position difference detector 780 detects a position difference d₁, and then outputs a corresponding phase-adjusting signal to the phase-controllable frequency divider 760. Therefore, the phase-controllable frequency divider 760 adjusts the phase of an outputted frequency-divided signal. When the next data block DATA₂' is recorded, the position difference d₂ is less than the original position difference d₁. Similarly, compared with the previous position difference d₂, a position difference d₃ is smaller. In the end, the ending bit of the data block DATA₄' is aligned to a correct position. That is, the prior art phase shift is compensated by the PLL system 710 through adjusting the phase of the output clock. Because the output clock drives the encoder 800 to produce the recording data, the length of a new recording data block is according reduced after the phase shift imposed upon the output clock is alleviated.

Concerning the track TRACK₀", it shows a data block DATA₁"affected by the prior art phase shift. Compared with the data block DATA₁, this data block DATA₁" has a shorter data length. Therefore, the position difference detector 780 detects a position difference D₁, and then outputs a corresponding phase-adjusting signal to the phase-controllable frequency divider 760. Therefore, the phase-controllable frequency divider 760 adjusts the phase of an outputted frequency-divided signal. When the next data block DATA₂" is recorded, the position difference D₂ is less than the original position difference D₁. Similarly, compared with the previous position difference D₂, a position difference D₃ is smaller. In the end, the ending bit of the data block DATA₄" is aligned to a correct position. That is, the prior art phase shift is compensated by the PLL system 710 through adjusting the phase of the output clock. Because the output clock drives the encoder 800 to produce the recording data, the length of a new recording data block is according increased after the phase shift imposed upon the output clock is alleviated.

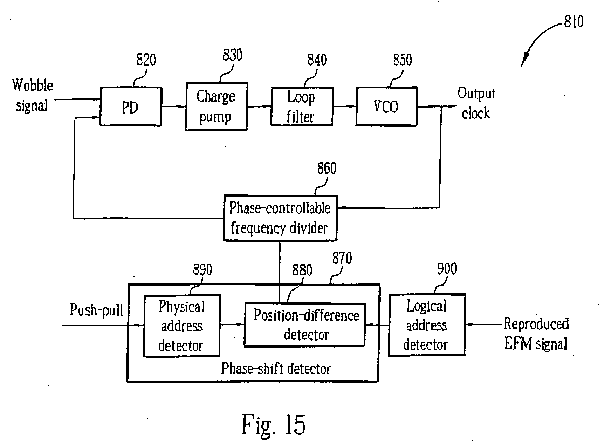

Please refer to Fig.15, which is a block diagram of a PLL system 810 according to a seventh detailed embodiment of the present invention. This embodiment is similar to the sixth detailed embodiment shown in Fig.13. The only difference is that the phase-shift detector 870 comprises not only a position difference detector 880 and a physical address detector 790, but also a logical address detector 900. The logical address detector 900 is utilized to receive the reproduced EFM signal read from the recordable optical disk and output logical addresses to the position difference detector 880 according to the reproduced EFM signal. Please note that the logical addresses correspond to the actual physical addresses of the recording data stored on the recordable optical disk. Therefore, the position difference detector 880 is capable of detecting a position difference between an ideal physical address and the logical address for the recording data on the recordable optical disk to generate the phase-adjusting signal.

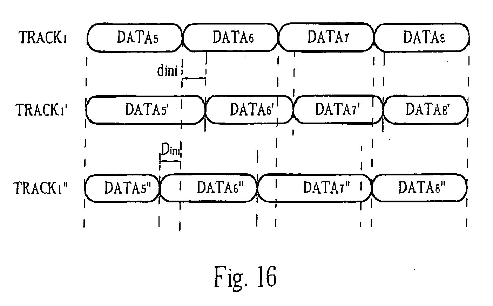

Please note that, in this embodiment, the phase-shift detector 870 detects the position difference from the physical address and the logical address all read from the recordable optical disc. Please refer to Fig. 16, which is a diagram illustrating the operation of the PLL system 810 shown in Fig.15. Alike Fig.16, the track TRACK₁ shows the ideal positions of a plurality of data blocks DATA₅, DATA₆, DATA₇, DATA₈. It is obvious that each of the data blocks DATA₅, DATA₆, DATA₇, DATA₈ has an identical data length.

Concerning a data block DATA₅' recorded onto a recordable optical disk, this data block DATA₅' is affected by the phase shift to have a data length longer than a desired data length defined by the data block DATA₅. Therefore, when the logical address detector 90 receives the reproduced EFM signal generated from the data block DATA₅' recorded on the recordable disk, the logical address detector 90 detects a logical address of the data block DATA₅'. At the same time, a physical address associated with the data block DATA₅' stored on the recordable optical disk is detected by the physical address detector 890 through a well-known push-pull signal read from the recordable optical disk. Then, the position difference detector 880 outputs a phase-adjusting signal to the phase-controllable frequency divider 880 according to an initial position difference dᵢₙᵢ. Therefore, the phase-controllable frequency divider 860 adjusts the phase of an outputted frequency-divided signal. Before a next data block is recorded, the data length of the next data block is adjusted because the phase shift imposed upon the output clock is alleviated with the help of the phase-controllable frequency divider 880. Therefore, the data length of the data block DATA₆' is predetermined before the data block DATA₆' is recorded onto the recordable optical disk. In this embodiment, the phase-shift detector 870 does not detect the position difference of the recorded data block DATA₆'. Because the actual position offset of the data block DATA₅', that is, the initial position difference dᵢₙᵢ is memorized in the beginning, the data lengths of following data blocks are gradually reduced after the phase shift imposed upon the output clock is gradually alleviated with the help of the phase-controllable frequency divider 880. For example, after the data block₆' is recorded, the phase-shift detector outputs a phase-shift signal with an offset value to the phase-controllable divider 860 according to the memorized initial position difference dᵢₙᵢ. Similarly, the data length of the next data block DATA₇' is predetermined before the data block DATA₇' is recorded, and after the data block₇' is recorded, the phase-shift detector outputs a phase-shift signal with an offset value to the phase-controllable divider 860 according to the memorized initial position difference dᵢₙᵢ. In the end, the ending bit of the data block DATA₈' is aligned to a correct position. That is, the prior art phase shift is compensated by the PLL system 710 through adjusting the phase of the output clock.

Concerning a data block DATA₅" recorded onto the recordable optical disk, this data block DATA₅" is affected by the phase shift to have a data length shorter than a desired data length defined by the data block DATA₅. Therefore, when the logical address detector 90 receives the reproduced EFM signal generated from the data block DATA₅" recorded on the recordable disk, the logical address detector 90 detects a logical address of the data block DATA₅". At the same time, a physical address associated with the data block DATA₅" stored on the recordable optical disk is detected by the physical address detector 890 through a well-known push-pull signal read from the recordable optical disk. Then, the position difference detector 880 outputs a phase-adjusting signal to the phase-controllable frequency divider 880 according to an initial position difference Dᵢₙᵢ. Therefore, the phase-controllable frequency divider 860 adjusts the phase of an outputted frequency-divided signal. Before a next data block is recorded, the data length of the next data block is adjusted because the phase shift imposed upon the output clock is alleviated with the help of the phase-controllable frequency divider 880. Therefore, the data length of the data block DATA₆" is predetermined before the data block DATA₆" is recorded onto the recordable optical disk. After the data block₆" is recorded, the phase-shift detector outputs a phase-shift signal with an offset value to the phase-controllable divider 860 according to the memorized initial position difference Dᵢₙᵢ. Similarly, the data length of the next data block DATA₇" is predetermined before the data block DATA₇" is recorded, and after the data block₇" is recorded, the phase-shift detector outputs a phase-shift signal with an offset value to the phase-controllable divider 860 according to the memorized initial position difference Dᵢₙᵢ. In the end, the ending bit of the data block DATA₈' is aligned to a precise position.

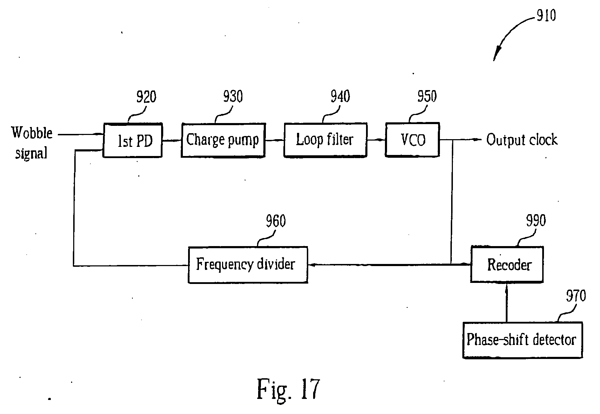

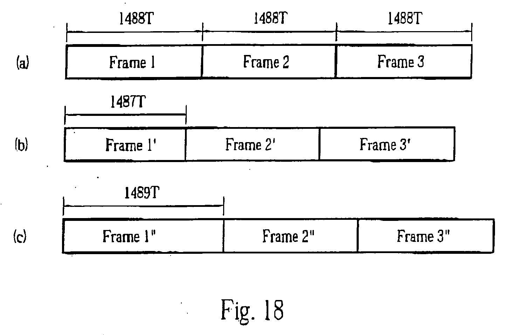

Please refer to Fig.17, which is a block diagram of another system 910 according to the present invention. The system 910 includes a recorder 990, a phase-shift detector 970, a phase detector (PD) 920, a charge pump 930, a loop filter 940, a voltage-controlled oscillator (VCO) 950, and a frequency divider 960. The function of the PD 920, the charge pump 930, the loop filter 940, the VCO 950, and a frequency divider 960 is the same as that of the those components of the same name in the related art PLL 10, and the function of the phase-shift detector 970 is the same as that of the PLL system 110, so that lengthy description is omitted here for simplicity. The recorder 990 receives the output clock from the VCO 950 as the reference clock for recording data, and further receives the phase-adjusting signal from the phase-shift detector 970 for inserting or deleting one bit or more of recording data to be recorded. Please refer to Fig.18 which is a timing diagram illustrating the operations of the recorder 990 in the application of DVD+R/RW or DVD-RW, where a normal frame of recording data contains 1488 recording bits. As shown in Fig. 18(a), if the phase-shift detector 970 is disabled, the length of the frame 1, frame 2, and frame 3 is normal and equal to 1488T. As shown in Fig. 18(b), when the phase-shift detector 970 detects that the phase of the output lock lags the ideal phase, the recorder 990 deletes the last bit of the frame 1' and the deleted bit is discarded to be recorded, which leads the position of the following frame 2' and frame 3'. As shown in Fig. 18(c), when the phase-shift detector 970 detects that the phase of the output lock leads the ideal phase, the recorder 990 inserts one dummy bit at the end of the frame 1" and the inserted dummy bit is recorded, which lags the position of the following frame 2" and frame 3". By deleting or inserting one bit at the end of a frame according to the phase-adjusting signal, the recorder 990 can compensate the phase shift detected by the phase-shift detector 970.

In contrast to the prior art, the present invention provides a phase-controllable frequency divider positioned at the feedback path. Therefore, the problem of prior art phase shift phenomenon is solved through tuning the phase-controllable frequency divider, and the recording quality is greatly improved. Besides, no matter how big the phase shift is, the claimed invention is capable of making the phase of an output clock locked to a correct phase.

## Claims

1. A phase locked loop (PLL) system (110, 210, 310, 410, 510, 610, 710, 810, 910) for generating an output signal according to a first reference signal, the output signal being used as a reference clock to write recording data on an optical medium, the PLL system (110, 210, 310, 410, 510, 610, 710, 810, 910) comprising:
a clock generator for receiving the first reference signal and a first frequency-divided signal to generate the output signal according to a phase difference between the first reference signal and the first frequency-divided signal;
**characterized by**:
a phase-shift detector (170, 270, 370, 470, 570, 670, 770, 870, 970) for generating a phase adjusting signal; and
a phase-controllable frequency divider (160, 260, 360, 460, 560, 660, 760, 860) electrically connected to the clock generator and the phase-shift detector (170, 270, 370, 470, 570, 670, 770, 870, 970) for dividing the output signal according to a frequency dividing ratio to generate the first frequency-divided signal and for receiving the phase adjusting signal to adjust the frequency dividing ratio.

2. The PLL system (110, 210, 310, 410, 510, 610, 710, 810, 910) of claim 1 **characterized in that** the phase-controllable frequency divider (160, 260, 360, 460, 560, 660, 760, 860) comprises a counter (162) for counting the output signal to generate a count value, wherein the phase-controllable frequency divider (160, 260, 360, 460, 560, 660, 760, 860) controls the first frequency-divided signal to toggle when the count value reaches a predetermined value.

3. The PLL system (110, 210, 310, 410, 510, 610, 710, 810, 910) of claim 2 **characterized in that** the phase-shift detector (170, 270, 370, 470, 570, 670, 770, 870, 970) utilizes the phase adjusting signal to adjust the count value counted by the phase-controllable frequency divider (160, 260, 360, 460, 560, 660, 760, 860) for adjusting the frequency dividing ratio.

4. The PLL system (110, 210, 310, 410, 510, 610, 710, 810, 910) of claim 1 **characterized in that** the first reference signal is a wobble signal generated from the optical medium.

5. The PLL system (110, 210, 310, 410, 510, 610, 710, 810, 910) of claim 4 **characterized in that** the phase-shift detector (170, 270, 370, 470, 570, 670, 770, 870, 970) comprises:
a frequency divider (290) for dividing the output signal to generate a second frequency-divided signal; and
a phase difference detector (280, 380, 480, 580, 680) electrically connected to the frequency divider (290) for detecting a phase difference between the second frequency-divided signal and the wobble signal to generate the phase adjusting signal.

6. The PLL system (210, 310, 410, 510, 610, 710, 810,910) of claim 5
**characterized in that** the frequency of the second frequency-divided signal is less than the frequency of the wobble signal.

7. The PLL system (110, 210, 310, 410, 510, 610, 710, 810, 910) of claim 4 **characterized in that** the phase-shift detector (170, 270, 370, 470, 570, 670, 770, 870, 970) comprises:
a first frequency divider (390) for dividing the output signal to generate a second frequency-divided signal;
a second frequency divider (400) for dividing the wobble signal to generate a third frequency-divided signal; and
a phase difference detector (280, 380, 480, 580, 680) electrically connected to the first and second frequency dividers (390 and 400 respectively) for detecting a phase difference between the second frequency-divided signal and the third frequency-divided signal to generate the phase adjusting signal.

8. The PLL system (310, 410, 510, 610, 710, 810, 910) of claim 7 **characterized in that** the frequency of the second frequency-divided signal is less than the frequency of the third frequency-divided signal.

9. The PLL system (110, 210, 310, 410, 510, 610, 710, 810, 910) of claim 4 **characterized in that** the phase-shift detector (170, 270, 370, 470, 570, 670, 770, 870, 970) detects a phase difference between the wobble signal and a recording synchronization signal synchronous to the recording data for generating the phase adjusting signal.

10. The PLL system (110, 210, 310, 410, 510, 610, 710, 810, 910) of claim 9 **characterized in that** the optical medium is a DVD-R/RW disc, and the recording synchronization signal complies with a DVD-R/RW specification.

11. The PLL system (110, 210, 310,410, 510, 610, 710, 810, 910) of claim 9 **characterized in that** the optical medium is a DVD+R/RW disc, and the recording synchronization signal complies with a DVD+R/RW specification.

12. The PLL system (110, 210, 310, 410, 510, 610, 710, 810, 910) of claim 4 **characterized in that** the phase-shift detector (170, 270, 370, 470, 570, 670, 770, 870, 970) comprises:
a frequency divider (290, 960) for dividing the wobble signal to generate a second frequency-divided signal; and
a phase difference detector (280, 380, 480, 580, 680) electrically connected to the frequency divider (290, 960) for detecting a phase difference between the second frequency-divided signal and a recording synchronization signal synchronous to the recording data to generate the phase adjusting signal.

13. The PLL system (110, 210, 310, 410, 510, 610, 710, 810, 910) of claim 4 **characterized in that** the optical medium is a DVD+R/RW disc, and the phase-shift detector (170, 270, 370, 470, 570, 670, 770, 870, 970) comprises:
an ADIP sync detector (590, 700) for detecting a beginning of an ADIP unit to generate an ADIP synchronization signal;
a frequency divider (290, 960) for dividing the output signal to generate a second frequency-divided signal; and
a phase difference detector (280, 380, 480, 580, 680) electrically connected to the frequency divider (290, 960) and the ADIP sync detector (590, 700) for detecting a phase difference between the second frequency-divided signal and the ADIP synchronization signal to generate the phase adjusting signal.

14. The PLL system (510, 610) of claim 13 **characterized in that** the frequency of the second frequency-divided signal is less than the frequency of the ADIP synchronization signal.

15. The PLL system (110, 210, 310, 410, 510, 610, 710, 810, 910) of claim 4 **characterized in that** the optical medium is a DVD+R/RW disc, and the phase-shift detector (170, 270, 370, 470, 570, 670, 770, 870, 970) comprises:
an ADIP sync detector (590, 700) for detecting a beginning of an ADIP unit to generate anADIP synchronization signal; and
a phase difference detector (280, 380, 480, 580, 680) electrically connected to the ADIP sync detector (590, 700) for detecting a phase difference between the ADIP synchronization signal and a recording synchronization signal synchronous to the recording data to generate the phase adjusting signal.

16. The PLL system (110, 210, 310, 410, 510, 610, 710, 810, 910) of claim 4 **characterized in that** the optical medium is a DVD-R/RW disc, and the phase-shift detector (170, 270, 370, 470, 570, 670, 770, 870, 970) comprises:
a land-pre-pit (LPP) sync detector?*** for detecting LPP bits to generate an LPP synchronization signal;
a frequency divider (290, 960) for dividing the output signal to generate a second frequency-divided signal; and
a phase difference detector (280, 380, 480, 580, 680) electrically connected to the frequency divider (290, 960) and the LPP sync detector?*** for detecting a phase difference between the second frequency-divided signal and the LPP synchronization signal to generate the phase adjusting signal.

17. The PLL system (110, 210, 310, 410, 510, 610, 710, 810, 910) of claim 16 **characterized in that** the frequency of the second frequency-divided signal is less than the frequency of the LPP synchronization signal.

18. The PLL system (110, 210, 310, 410, 510, 610, 710, 810, 910) of claim 4 **characterized in that** the optical medium is a DVD-R/RW disc, and the phase-shift detector (170, 270, 370, 470, 570, 670, 770, 870, 970) comprises:
a land-pre-pit (LPP) sync detector for detecting LPP bits to generate an LPP synchronization signal; and
a phase difference detector (280, 380, 480, 580, 680) electrically connected to the LPP sync detector for detecting a phase difference between the LPP synchronization signal and a recording synchronization signal synchronous to the recording data to generate the phase adjusting signal.

19. The PLL system (110, 210, 310, 410, 510, 610, 710, 810, 910) of claim 4 **characterized in that** the phase-shift detector (170, 270, 370, 470, 570, 670, 770, 870, 970) comprises:
a physical address detector (790, 890) for detecting a predetermined physical address of a first data block of the recording data, wherein the predetermined physical address is used to define the position on the optical medium for storing the first data block; and
a position difference detector (780, 880) for detecting a first position difference between the predetermined physical address and an actual physical address to generate the phase adjusting signal, wherein the first data block is stored into the actual physical address instead of the predetermined physical address on the optical medium.

20. The PLL system (710, 810) of claim 19 **characterized in that** when a second data block following the first data block is written on the optical medium, the pbase-controllable frequency divider (160, 260, 360, 460, 560, 660, 760, 860) adjusts the frequency dividing ratio for reducing a second position difference between a predetermined physical address and an actual physical address of the second data block according to the first position difference detected by the position difference detector.

21. The PLL system (710, 810) of claim 20 **characterized in that** the position difference detector (780, 880) detects a plurality of position differences corresponding to a plurality of data blocks following the first data block for respectively outputting a plurality of phase adjusting signals corresponding to the position differences.

22. The PLL system (710, 810) of claim 20 **characterized in that** the position difference detector (780, 880) only detects the first position difference, and respectively outputs a plurality of phase adjusting signals corresponding to a plurality of data blocks following the first data block according to the first position difference, and the phase adjusting signals are determined before data blocks following the first data block are recorded on the optical medium.

23. The PLL system (110, 210, 310, 410, 510, 610, 710, 810, 910) of claim 1 **characterized in that** the optical medium is a DVD-R/RW disc.

24. The PLL system (110, 210, 310, 410, 510, 610, 710,810,910) of claim 1 **characterized in that** the optical medium is a DVD+R/RW disc.

25. A method for generating an output signal according to a first reference signal, the output signal being used as a reference clock to write recording data on an optical medium, the method **characterized by**:
receiving the first reference signal and a first frequency-divided signal to generate the output signal according to a phase difference between the first reference signal and the first frequency-divided signal;
generating a phase adjusting signal;
dividing the output signal according to a frequency dividing ratio to generate the first frequency-divided signal; and
receiving the phase adjusting signal to adjust the frequency dividing ratio.

26. The method of claim 25 **characterized by**:
counting the output signal to generate a count value, wherein the first frequency-divided signal toggles when the count value reaches a predetermined value.

27. The method of claim 26 **characterized by**:
utilizing the phase adjusting signal to adjust the count value for adjusting the frequency dividing ratio.

28. The method of claim 25 **characterized in that** the first reference signal is a wobble signal generated from the optical medium.

29. The method of claim 28 **characterized in that** generating the phase adjusting signal comprises:
dividing the output signal to generate a second frequency-divided signal; and
detecting a phase difference between the second frequency-divided signal and the wobble signal to generate the phase adjusting signal.

30. The method of claim 29 **characterized in that** the frequency of the second frequency-divided signal is less than the frequency of the wobble signal.

31. The method of claim 28 **characterized in that** generating the phase adjusting signal comprises:
dividing the output signal to generate a second frequency-divided signal; dividing the wobble signal to generate a third frequency-divided signal; and
detecting a phase difference between the second frequency-divided signal and the third frequency-divided signal to generate the phase adjusting signal.

32. The method of claim 31 **characterized in that** the frequency of the second frequency-divided signal is less than the frequency of the third frequency-divided signal.

33. The method of claim 28 **characterized in that** generating the phase adjusting signal comprises:
detecting a phase difference between the wobble signal and a recording synchronization signal synchronous to the recording data for generating the phase adjusting signal.

34. The method of claim 33 **characterized in that** the optical medium is a DVD-R/RW disc, and the recording synchronization signal complies with a DVD-R/RW specification.

35. The method of claim 33 **characterized in that** the optical medium is a DVD+R/RW disc, and the recording synchronization signal complies with a DVD+R/RW specification.

36. The method of claim 28 **characterized in that** generating the phase adjusting signal comprises:
dividing the wobble signal to generate a second frequency-divided signal; and
detecting a phase difference between the second frequency-divided signal and a recording synchronization signal synchronous to the recording data for generating the phase adjusting signal.

37. The method of claim 28 **characterized in that** the optical medium is a DVD+R/RW disc, and generating the phase adjusting signal comprises; detecting a beginning of an ADIP unit to generate an ADIP synchronization signal; dividing the output signal to generate a second frequency-divided signal; and detecting a phase difference between the second frequency-divided signal and the ADIP synchronization signal to generate the phase adjusting signal.

38. The method of claim 37 **characterized in that** the frequency of the second frequency-divided signal is less than the frequency of the ADIP synchronization signal.

39. The method of claim 28 **characterized in that** the optical medium is a DVD+R/RW disc, and generating the phase adjusting signal comprises:
detecting a beginning of an ADIP unit to generate an ADIP synchronization signal; and
detecting a phase difference between the ADIP synchronization signal and a recording synchronization signal synchronous to the recording data to generate the phase adjusting signal.

40. The method of claim 28 **characterized in that** the optical medium is a DVD+R/RW disc, and generating the phase adjusting signal comprises:
detecting LPP bits to generate an LPP synchronization signal;
dividing the output signal to generate a second frequency-divided signal; and
detecting a phase difference between the second frequency-divided signal and the LPP synchronization signal to generate the phase adjusting signal.

41. The method of claim 40 **characterized in that** the frequency of the second frequency-divided signal is less than the frequency vf the LPP synchronization signal.

42. The method of claim 28 **characterized in that** the optical medium is a DVD-R/RW disc, and generating the phase adjusting signal comprises:
detecting LPP bits to generate an LPP synchronization signal; and
detecting a phase difference between the LPP synchronization signal and a recording synchronization signal synchronous to the recording data for generating the phase adjusting signal.

43. The method of claim 28 **characterized in that** generating the phase adjusting signal comprises:
detecting a predetermined physical address of a first data block of the recording data, wherein the predetermined physical address is used to define the position on the optical medium for storing the first data block; and
detecting a first position difference between the predetermined physical address and an actual physical address to generate the phase adjusting signal, wherein the first data block is actually stored into the actual physical address instead of the predetermined physical address on the optical medium.

44. The method of claim 43 **characterized in that** when a second data block following the first data block is written on the optical medium, the frequency dividing ratio is adjusted for reducing a second position difference between a predetermined physical address and an actual physical address of the second data block according to the first position difference.

45. The method of claim 44 **characterized in that** a plurality of position differences corresponding to a plurality of data blocks following the first data block are detected for respectively outputting a plurality of phase adjusting signals corresponding to the position differences.

46. The method of claim 44 **characterized in that** only the first position difference is detected, a plurality of phase adjusting signals corresponding to a plurality of data blocks following the first data block are respectively outputted according to the first position difference, and the phase adjusting signals are determined before data blocks following the first data block are recorded on the optical medium..

47. The method of claim 25 **characterized in that** the optical medium is a DVD-R/RW disc.

48. The method of claim 25 **characterized in that** the optical medium is a DVD+R/RW disc.
